# FASCICULE DE BREVET EUROPEEN

(11) **EP 3 255 723 B1**
(45) Date de publication et mention de la délivrance du brevet: **08.01.2020**
(21) Numéro de dépôt: 17175268.6
(22) Date de dépôt: 09.06.2017
(51) Int. Cl.: H01P 1/10, H03G 11/00, H01L 39/16, H01L 39/24

(54) **DISPOSITIF ÉLECTRONIQUE AVEC LIMITEUR DE PUISSANCE RADIOFRÉQUENCE**
ELEKTRONISCHE VORRICHTUNG MIT RADIOFREQUENZ-LEISTUNGSBEGRENZER
ELECTRONIC DEVICE WITH RADIOFREQUENCY POWER LIMITER

(30) Priorité: 09.06.2016 FR 1600942
(43) Date de publication de la demande: 13.12.2017
(73) Titulaire: Thales, 92400 Courbevoie (FR); CENTRE NATIONAL DE LA RECHERCHE SCIENTIFIQUE, 75016 Paris (FR)
(72) Inventeur: D'ALLIVY KELLY, Olivier, 91767 PALAISEAU (FR); MARCILHAC, Bruno, 91767 PALAISEAU (FR); LEMAITRE, Yves, 91767 PALAISEAU (FR); KERMORVANT, Julien, 91767 PALAISEAU (FR); VILLEGAS, Javier, 92140 CLAMART (FR); TRASTOY QUINTELA, Juan, LA JOLLA, CA 92037 (US)
(74) Mandataire: Lavoix

(56) Documents cités:
- EP-A1- 0 707 349
- US-A- 5 585 330
- HARRIOTT L R ET AL: "Focused ion beam modification and patterning of high Tc superconductors", ELECTRON-BEAM, X-RAY AND ION-BEAM TECHNOLOGY: SUBMICROMETER LITHOGRAPHIES IX, SAN JOSE, CA, USA; PROCEEDINGS OF SPIE, vol. 1263, 1990, pages 53-61, XP055350585, ISSN: 0277-786X, DOI: 10.1117/12.20144
- VORONOV B M ET AL: "Fast superconducting microwave switch based on electron heating", SUPERCONDUCTIVITY: PHYSICS, CHEMISTRY, TECHNOLOGY, vol. 4, no. 2, février 1991 (1991-02), pages 336-340, XP009193599, ISSN: 0235-8964

## Description

La présente invention concerne un dispositif électronique de traitement d'ondes radiofréquences comportant un limiteur de puissance radiofréquence. La présente invention se rapporte également à un procédé de fabrication associé.

L'invention appartient au domaine des systèmes de transmission et de traitement du signal radiofréquence. Plus spécifiquement, l'invention se rapporte à la limitation de puissance radiofréquence.

Les limiteurs de puissance sont employés dans un grand nombre de systèmes de communication. La fonction principale d'un limiteur est de protéger un circuit électronique d'un signal radiofréquence ayant une puissance supérieure à une valeur de seuil prédéfinie. A titre d'illustration, pour des valeurs de champ électrique suffisamment grandes, le fonctionnement de certains composants électroniques est altéré voire détérioré de manière permanente. De tels rayonnements néfastes sont, par exemple, générés par des émetteurs radars, des stations de télécommunication ou des brouilleurs.

Dans les récepteurs radiofréquences, les limiteurs se retrouvent prioritairement en début de chaîne de réception, juste après l'antenne et généralement en entrée d'un amplificateur faible bruit. Un amplificateur faible bruit est souvent désigné sous l'acronyme LNA qui renvoie à l'expression anglaise « low-noise amplifier » qui signifie « amplificateur faible bruit ».

Dans un tel cas, l'amplificateur comporte des transistors présentant une tenue en puissance relativement faible. De tels composants sont donc susceptibles d'être affectés par une détérioration ou une réduction de performances.

Il est donc souhaitable de protéger l'ensemble des composants électroniques d'une chaîne de réception des conséquences d'une exposition à des valeurs de champ électromagnétique trop grandes.

Il est connu d'utiliser des limiteurs pour protéger ces composants. Par exemple, il est employé une diode PIN (acronyme de l'anglais « Positive Intrinsic Négative » signifiant « positif intrinsèque négatif »). Une diode PIN est une diode constituée d'une zone non-dopée, dite intrinsèque I, intercalée entre deux zones dopées P et N. Une telle diode PIN est, par exemple, réalisée en un matériau GaAs.

Néanmoins, de tels composants présentent des pertes d'insertion relativement élevées, une bande passante limitée, une tenue en puissance limitée ou un fonctionnement en fusible impliquant alors l'altération irréversible et donc le remplacement du composant. De plus, pour de tels composants, sont observés des régimes transitoires et de la génération d'harmoniques.

Dans certaines applications, les limitations précitées sont incompatibles avec la capacité souhaitée de pouvoir analyser des signaux radiofréquence avec une importante gamme dynamique sur une large bande spectrale.

Pour ces applications, il a été identifié qu'il convient d'utiliser des limiteurs radiofréquence capables de ne pas dégrader le signal détecté, au moins dans leur régime de fonctionnement non bloqué.

Pour cela, il a été proposé d'employer des composants utilisant des matériaux supraconducteurs à haute température critique (aussi désignés par l'acronyme HTS) présentant l'avantage de bénéficier notamment d'une large bande passante et de pertes d'insertions extrêmement faibles. Les Limiteurs de Puissance Micro-Onde Supraconducteurs (aussi désignés par l'acronyme LPMS) permettent en particulier de remédier à la plupart des limitations précitées. De tels limiteurs présentent des pertes d'insertion strictement inférieures à 0,5 dB/cm (déciBel par centimètre) à 70K (Kelvin) jusqu'à 40GHz (GigaHertz) et un temps d'établissement strictement inférieur à 10 ns (nanosecondes). De plus, de tels limiteurs ont un fonctionnement réversible démontré jusqu'à 10 W (Watts) en onde continue, un réamorçage automatique, une puissance limite ajustable en changeant la géométrie ou la température de fonctionnement et une impédance constante sur plus de 40 GHz.

Par ailleurs, il est observé une limitation de la puissance dans l'état passant de tels limiteurs de Puissance Micro-Onde Supraconducteurs. La limitation de puissance obtenue dans les matériaux HTS résulte d'une dégradation des propriétés de supraconduction en raison de divers mécanismes microscopiques activés par le rayonnement hyperfréquence et susceptibles de déplacer le système supraconducteur hors de son état d'équilibre. En particulier, les mécanismes de destruction de paires (aussi désigné par le terme anglais « pair breaking »), de désancrage de vortex magnétiques et d'effet Joule d'électrons non appariés sont impliqués. Le dépassement d'une puissance de seuil entraine une augmentation de la température au-delà de la température critique. Il s'en suit un effet d'emballement sur ces mécanismes de relaxation aboutissant à une perte de la supraconductivité et, par voie de conséquence, une limitation/diminution du signal transmis.

Pour résoudre ce problème, il a été proposé un dispositif spécifique dans l'article de J.C. Booth et al. intitulé « A Self-Attenuating Superconducting Transmission Line for Use as a Microwave Power Limiter » dans la revue IEEE TRANSACTIONS ON APPLIED SUPERCONDUCTIVITY, volume 13, numéro 2 en date de juin 2003. Le dispositif repose sur l'emploi de guides d'ondes coplanaires, dans des structures où le conducteur central présente une largeur typique de l'ordre de la dizaine de micromètres, le confinement du courant radiofréquence aboutissant au fonctionnement précédemment décrit.

EP 0 707 349 A1 divulgue un commutateur hyperfréquence à base d'un guide d'ondes coplanaire en supraconducteur HTS semblable, avec un conducteur central ayant un segment de largeur et/ ou d'épaisseur réduite, et/ou de matériau sélectivement irradié.

Toutefois, les guides d'ondes coplanaires présentent un certain nombre de limitations en termes d'intégration dont il est souhaitable de s'affranchir.

L'emploi d'un conducteur central de plusieurs centaines micromètres de large (souvent désigné sous le terme anglais de « microstrip » pour microbande) permet une meilleure intégration avec d'autres composants (comme des filtres par exemple) employés pour le traitement analogique du signal.

Néanmoins, dans un tel cas, contrairement aux guides d'ondes coplanaires, il est difficile d'ajuster correctement les critères de performance que sont la puissance de seuil ainsi que les temps de commutation et de réamorçage en agissant sur la géométrie de la ligne.

Il existe donc un besoin pour un dispositif électronique de traitement d'ondes radiofréquences comportant un limiteur de puissance radiofréquence qui soit de mise en oeuvre plus aisée.

Pour cela, il est décrit un dispositif électronique de traitement d'ondes radiofréquences comportant une ligne, la ligne présentant une deuxième géométrie et étant réalisée en un deuxième matériau supraconducteur, la ligne présentant une phase normale, une phase supraconductrice et une température de transition entre la phase supraconductrice et la phase normale, dite deuxième température de transition, la ligne comportant un limiteur de puissance radiofréquence, le limiteur ayant un premier mode de fonctionnement et un deuxième mode de fonctionnement, le limiteur étant réalisé sous forme d'une portion de la ligne présentant une première géométrie et étant réalisée en un premier matériau supraconducteur, la portion présentant une phase supraconductrice et une phase normale, une température de transition vers la phase supraconductrice, dite première température de transition, le limiteur étant dans le premier mode de fonctionnement lorsque la portion est dans la phase supraconductrice et le limiteur étant dans le deuxième mode de fonctionnement lorsque la portion est dans la phase normale, au moins l'un parmi la première géométrie et le premier matériau supraconducteur différant de la deuxième géométrie et du deuxième matériau supraconducteur pour que la première température de transition soit strictement inférieure à la deuxième température de transition, le premier matériau supraconducteur comportant au moins une première zone en un troisième matériau supraconducteur et au moins une deuxième zone réalisée en deuxième matériau supraconducteur, le troisième matériau supraconducteur étant différent du premier matériau supraconducteur et du deuxième matériau supraconducteur.

Suivant des modes de réalisation particuliers, le dispositif comprend une ou plusieurs des caractéristiques suivantes, prise(s) isolément ou suivant toutes les combinaisons techniquement possibles :
- la différence entre la première température de transition et la deuxième température de transition est supérieure ou égale à 10 K.
- la différence entre la première température de transition et la deuxième température de transition est supérieure ou égale à 20 K.
- le premier matériau supraconducteur est obtenu à partir du deuxième matériau supraconducteur par implantations d'ions.
- la deuxième zone est continue.
- chaque première zone présente la forme d'un disque.
- le premier matériau supraconducteur comporte des défauts destinés à piéger des vortex.

Il est également décrit un procédé de fabrication d'un dispositif électronique de traitement d'ondes radiofréquences, le procédé comprenant la fourniture d'une ligne présentant une deuxième géométrie et étant réalisée en un deuxième matériau supraconducteur, la ligne présentant une phase normale, une phase supraconductrice et une température de transition entre la phase supraconductrice et la phase normale, dite deuxième température de transition, et l'application d'un traitement sur une portion de la ligne pour obtenir un limiteur de puissance radiofréquence, le limiteur ayant un premier mode de fonctionnement et un deuxième mode de fonctionnement, le limiteur étant réalisé sous forme d'une portion de la ligne présentant une première géométrie et étant réalisée en un premier matériau supraconducteur, la portion présentant une phase supraconductrice et une phase normale, une température de transition vers la phase supraconductrice, dite première température de transition, le limiteur étant dans le premier mode de fonctionnement lorsque la portion est dans la phase supraconductrice et le limiteur étant dans le deuxième mode de fonctionnement lorsque la portion est dans la phase normale, au moins l'un parmi la première géométrie et le premier matériau supraconducteur différant de la deuxième géométrie et du deuxième matériau supraconducteur pour que la première température de transition soit strictement inférieure à la deuxième température de transition, le premier matériau supraconducteur comportant au moins une première zone en un troisième matériau supraconducteur et au moins une deuxième zone réalisée en deuxième matériau supraconducteur, le troisième matériau supraconducteur étant différent du premier matériau supraconducteur et du deuxième matériau supraconducteur.

D'autres caractéristiques et avantages de l'invention apparaîtront à la lecture de la description qui suit de modes de réalisation de l'invention, donnée à titre d'exemple uniquement et en référence aux dessins qui sont :
- figure 1, une vue schématique d'un exemple de dispositif électronique de traitement d'ondes radiofréquences comportant un limiteur de puissance radiofréquence,
- figure 2, un graphique présentant l'évolution de la résistance de surface R_{S} en fonction de la température pour un composant réalisé en matériau supraconducteur traité, la résistance de surface R_{S} étant la partie réelle de l'impédance de surface du matériau supraconducteur en régime radiofréquence, l'impédance de surface étant une grandeur permettant de caractériser la dissipation dans les matériaux en régime radiofréquence,
- figure 3, une vue schématique d'un composant réalisé en matériau supraconducteur traité,
- figure 4, un graphique présentant l'évolution de la résistance de surface en fonction de la température pour un composant réalisé en matériau supraconducteur non traité,
- figure 5, une vue schématique d'un composant réalisé en matériau supraconducteur non traité,
- figure 6, un graphique présentant l'évolution de la résistance en fonction de la température pour le dispositif de la figure 1,
- figure 7, une vue schématique d'un composant du dispositif de la figure 1 selon la présente invention,
- figure 8, un graphique présentant l'évolution de la résistance de surface en fonction de la température pour un autre exemple de dispositif électronique de traitement d'ondes radiofréquences comportant un limiteur de puissance radiofréquence,
- figure 9, une vue schématique de dessus d'une partie du dispositif de la figure 8,
- figure 10, une vue schématique de côté d'une partie du dispositif de la figure 8,
- figure 11, une vue schématique de dessus d'une partie d'un autre exemple de dispositif électronique de traitement d'ondes radiofréquences comportant un limiteur de puissance radiofréquence, et
- figure 12, une vue schématique de dessus d'une partie d'un autre exemple de dispositif électronique de traitement d'ondes radiofréquences comportant un limiteur de puissance radiofréquence.

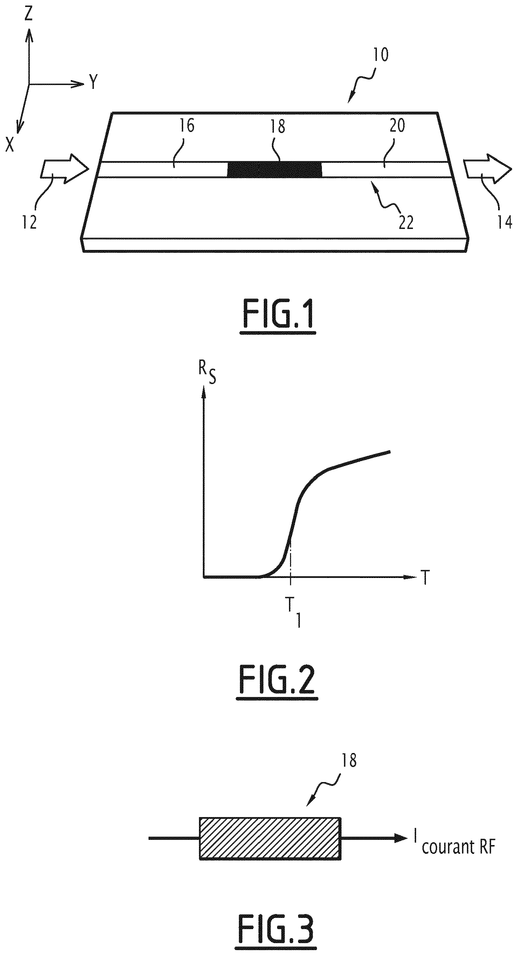

Un dispositif 10 électronique de traitement d'ondes radiofréquences est représenté sur la figure 1.

Par ondes radiofréquences, il est entendu une onde dont la fréquence est comprise entre 3 Hz et 300 GHz.

Le dispositif 10 est propre à modifier une onde incidente 12 en une onde émergente 14.

L'onde émergente 14 a subi un traitement par rapport à l'onde incidente 12.

Le dispositif 10 comporte une première unité 16, un limiteur 18 et une deuxième unité 20.

La première unité 16, la deuxième unité 20 et le limiteur 18 sont agencés pour qu'en fonctionnement, une onde incidente 12 traverse la première unité 16, puis le limiteur 18 et la deuxième unité 20.

Selon l'exemple de la figure 1, la première unité 16, la deuxième unité 20 et le limiteur 18 sont agencés pour former une ligne 22 de transmission.

La ligne 22 s'étend principalement selon une première direction symbolisée par l'axe Y sur la figure 1.

Une direction d'empilement symbolisée par l'axe Z sur la figure 1 est également définie. La deuxième direction est symbolisée par l'axe X sur la figure 1. La deuxième direction est perpendiculaire aux deux autres directions Z et Y.

La ligne 22 présente une deuxième géométrie G2 et est réalisée en un deuxième matériau supraconducteur M2.

La deuxième géométrie G2 est la forme en section transversale de la ligne 22 par rapport à la première direction Y.

Usuellement, la deuxième géométrie G2 est constante pour une ligne 22.

Du fait de la deuxième géométrie G2 et du deuxième matériau supraconducteur M2, la ligne 22 présente une température de transition entre la phase supraconductrice et la phase normale, dite deuxième température de transition T₂.

La première unité 16 assure une première fonction électrique différente du limiteur 18.

Par exemple, la première unité est une ligne supraconductrice de type « microstrip » adaptée à 50 Ohms.

La première unité 16 est propre à fonctionner à une première température de fonctionnement T_{f1}.

Par exemple, la première température de fonctionnement T_{f1} est comprise entre 70K et 80K.

La deuxième unité 20 assure une deuxième fonction électrique différente du limiteur 18.

Selon un mode de réalisation, la première fonction électrique et la deuxième fonction électrique sont distinctes.

La deuxième unité 20 est propre à fonctionner à une deuxième température de fonctionnement T_{f2}.

Selon un mode de réalisation, la première température de fonctionnement T_{f1} et la deuxième température de fonctionnement T_{f2} sont égales. Dans la suite, pour simplifier, chaque température de fonctionnement est noté T_{f}.

Le limiteur 18 est intercalé entre les deux unités 16 et 20.

Le limiteur 18 est relié d'une part à la première unité 16 et d'autre part à la deuxième unité 20.

Le limiteur 18 est un limiteur de puissance radiofréquence.

Le limiteur 18 présente un premier mode de fonctionnement MF1 et un deuxième mode de fonctionnement MF2.

Le limiteur 18 est réalisé sous forme d'une portion de la ligne 22 présentant une première géométrie G1.

La deuxième géométrie G2 est la forme en section transversale du limiteur 18 par rapport à la première direction Y.

En outre, le limiteur 18 est réalisé en un premier matériau supraconducteur M1.

De par la présence du premier matériau supraconducteur M1, la portion présente une phase supraconductrice et une phase normale.

La température de transition vers la phase supraconductrice est dite première température de transition T₁.

Le limiteur 18 est dans le premier mode de fonctionnement lorsque la portion est dans la phase supraconductrice.

Dans le premier mode de fonctionnement, une onde incidente traversant le limiteur 18 n'est pas atténuée.

Le limiteur 18 est dans le deuxième mode de fonctionnement lorsque la portion est dans la phase normale.

Dans le deuxième mode de fonctionnement, une onde incidente traversant le limiteur 18 est atténuée.

Dans l'exemple qui va être illustré, le premier matériau supraconducteur M1 et le deuxième matériau supraconducteur M2 sont différents tandis que la première géométrie G1 et la deuxième géométrie G2 sont identiques.

Dans ces conditions, il est possible de considérer que le premier matériau supraconducteur M1 est un matériau supraconducteur traité alors que le deuxième matériau supraconducteur M2 est un matériau supraconducteur non traité.

De plus, dans ce cas particulier, le matériau supraconducteur traité présente une température de transition entre la phase supraconductrice et la phase normale qui est la première température de transition T₁.

Une telle propriété est illustrée schématiquement par la figure 2 qui présente l'évolution de la résistance en fonction de la température pour un limiteur réalisé en matériau supraconducteur traité comme visible à la figure 3.

Le matériau supraconducteur non traité présente une température de transition entre la phase supraconductrice et la phase normale qui est la deuxième température de transition T₂.

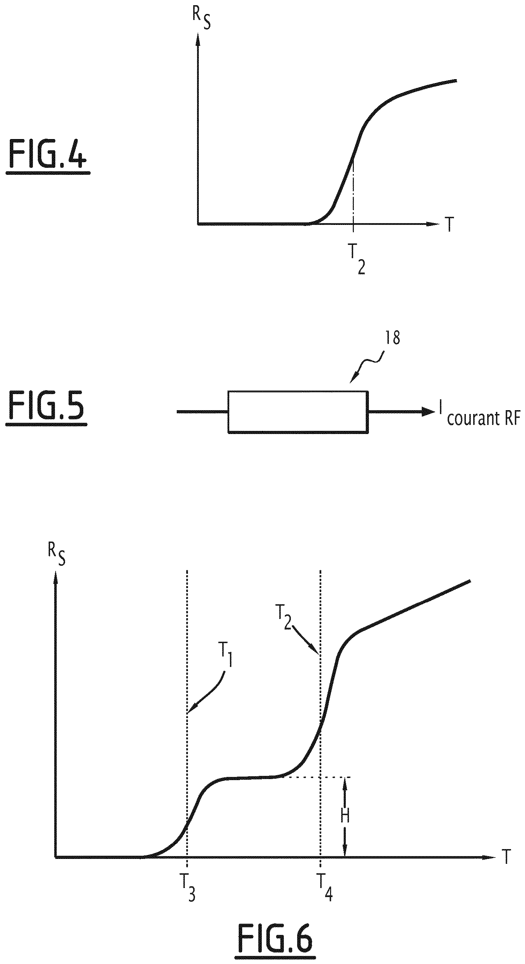

Une telle propriété est illustrée schématiquement par la figure 4 qui présente l'évolution de la résistance en fonction de la température pour un composant réalisé en matériau supraconducteur non traité comme visible à la figure 5.

Le matériau supraconducteur non traité est, par exemple, un supraconducteur à haute température critique.

Par exemple, le matériau supraconducteur est du YBa₂Cu₃O₇₋ₓ aussi désigné par l'acronyme YBCO.

La première température de transition T₁ est strictement inférieure à la deuxième température de transition T₂.

Selon un mode de réalisation, la différence entre la première température de transition T₁ et la deuxième température de transition T₂ est supérieure ou égale à 10 K.

Selon encore un autre mode de réalisation, la différence entre la première température de transition T₁ et la deuxième température de transition T₂ est supérieure ou égale à 20 K.

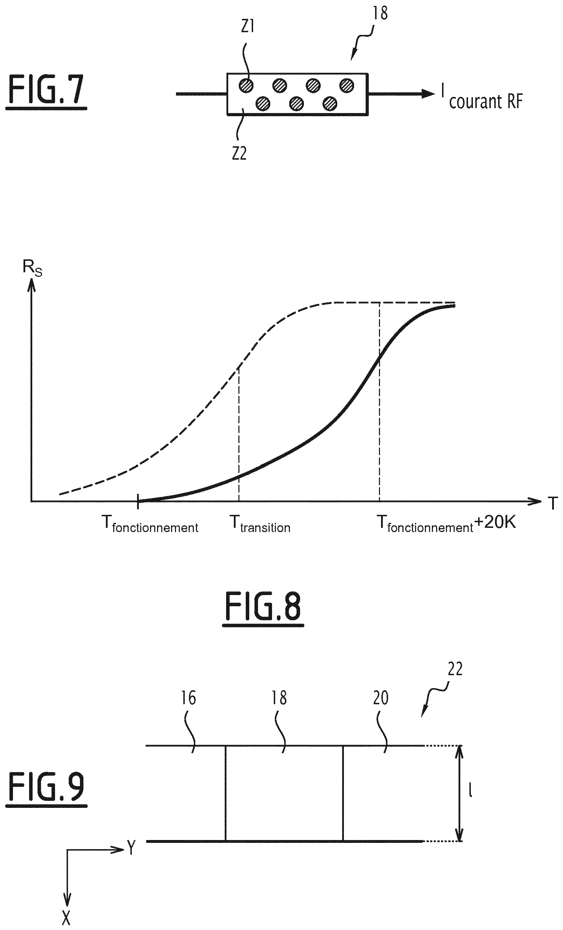

Un exemple particulier de limiteur 18 selon la présente invention est illustré par les figures 6 et 7.

Dans le cas particulier de la figure 7, le matériau supraconducteur traité comporte au moins une première zone Z1 réalisée en un troisième matériau supraconducteur M3 et au moins une deuxième zone Z2 réalisée en matériau supraconducteur non traité M2.

Le troisième matériau supraconducteur M3 est différent du premier matériau supraconducteur M1 et du deuxième matériau supraconducteur M2.

Plus précisément, selon l'exemple de la figure 7, la deuxième zone Z2 est continue et chaque première zone Z1 présente la forme d'un disque.

Le troisième matériau supraconducteur M3 présente une température de transition entre la phase supraconductrice et la phase normale, dite troisième température de transition T₃.

La première température de transition T₁ est égale à la troisième température de transition T₃.

De plus, le matériau supraconducteur non-traité présente une température de transition vers la phase normale, dite quatrième température de transition T₄, la quatrième température de transition T₄ étant égale à la deuxième température de transition T₂.

Cela est notamment illustré par la figure 6.

Le fonctionnement du limiteur 18 est maintenant décrit en référence à la figure 6.

Il apparaît que, pour un niveau de puissance d'entrée relativement faible, la puissance transmise n'est quasiment pas atténuée en raison des faibles pertes offertes par les composants supraconducteurs.

Au seuil de puissance, les dissipations thermiques inhérentes à la transmission radiofréquence dans les matériaux supraconducteurs, par ailleurs favorisées dans les zones irradiées, augmentent la température du limiteur 18 qui, toujours dans ces zones, se met à transiter vers l'état normal, entrainant davantage de dissipations et une accélération du phénomène jusqu'à la transition totale dans l'état normal de tout ou partie du limiteur 18.

En conséquence, la transmission du dispositif 10 est fortement dégradée, l'énergie radiofréquence est alors en partie renvoyée vers la source, en partie évacuée dans les zones non supraconductrices ce qui limite ainsi la puissance de l'onde émergente 14.

En résumé, le limiteur 18 se comporte comme un guide d'ondes supraconducteur, qui, lorsqu'il est soumis à un signal radiofréquence à une puissance importante, transmet ce signal avec un niveau de puissance moindre.

Selon un mode de réalisation particulier, la première unité 16 et la deuxième unité 20 sont propres à fonctionner à une température de fonctionnement qui est égale à la première température T₁. Dans ce cas particulier, le limiteur 18 est, en outre, aisément insérable dans le dispositif 10.

Le dispositif 10 présente l'avantage de présenter de bonnes performances tout en permettant de simplifier sa mise en œuvre.

De fait, il est aisé d'obtenir un dispositif ainsi que le montre un exemple de procédé de fabrication d'un tel dispositif, procédé qui est maintenant décrit.

Le procédé comporte une étape de fourniture de la ligne 22.

Le procédé comporte également une étape d'application d'un traitement sur le matériau supraconducteur pour obtenir un matériau supraconducteur traité.

De multiples possibilités sont à envisager pour le traitement appliqué.

Selon un exemple, le traitement appliqué est une technique de masquage.

Une technique de masquage conduit par exemple à modifier la géométrie du limiteur 18 pour passer de la deuxième géométrie G2 à la première géométrie G1.

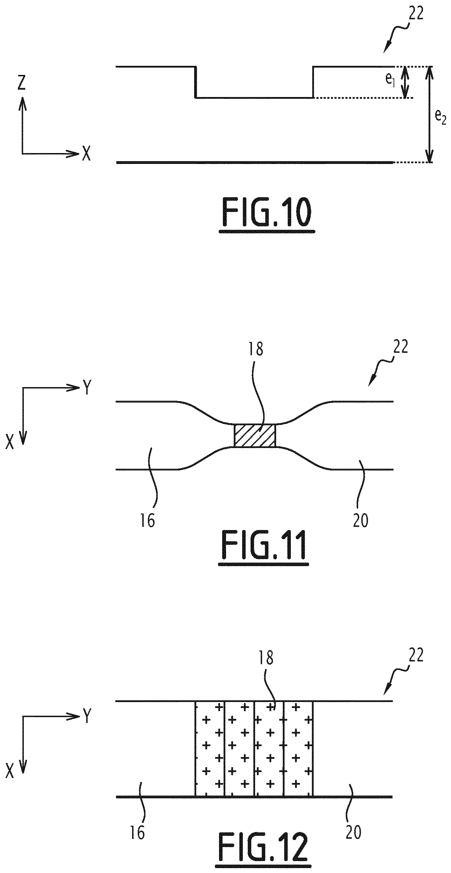

Selon l'exemple des figures 9 et 10, la portion présente la même extension que la ligne 22 selon la deuxième direction X.

Par contre, la portion présente une épaisseur diminuée selon la direction d'empilement Z par rapport à la ligne 22 qui présente une épaisseur e2. De fait, la portion délimite un trou d'épaisseur e1. L'épaisseur de la portion traitée est donc e2 - e1 alors que l'épaisseur de la ligne 22 est e2.

Le limiteur 18 obtenu présente le fonctionnement souhaité.

Selon un autre exemple notamment illustré par la figure 11, le limiteur 18 présente un rétrécissement le long de la deuxième direction X.

Une telle modification de la première géométrie G1 permet de modifier le courant critique.

Selon un autre exemple, le traitement appliqué est une irradiation d'ions conduisant à l'implantation d'ions.

A titre d'exemple, des ions irradiés sont des ions oxygène.

Le limiteur obtenu est schématisé sur la figure 12.

Selon une variante, les ions sont irradiés sur des parties du limiteur (par exemple, une seule zone limitée par des tranches verticales sur la figure 12).

En variante, le traitement appliqué est une désoxygénation par recuit. Un tel traitement utilise, par exemple, un masque métallique et un moyen de chauffage.

Selon une autre variante, une ou plusieurs des techniques précédemment décrites sont mises en œuvre lors de l'étape d'application.

Notamment, il est possible de combiner les cas des figures 10 et 12 en modifiant la forme de la portion et en implantant des ions dans la portion.

Par exemple, pour obtenir le dispositif 10 de la figure 1, il est mis en œuvre une étape de lithographie optique ou électronique permettant de définir une zone à irradier ainsi que le motif à irradier. Il est ensuite mis en œuvre une irradiation ionique permettant d'implanter des ions oxygène au sein du matériau supraconducteur non traité pour altérer localement les propriétés supraconductrices du matériau supraconducteur non traité.

Dans un tel cas, la puissance de seuil ou le temps de réamorçage du limiteur 18 sont fonctions du degré d'implantation ionique ainsi que de la morphologie de la ou des zones traitées.

Le procédé proposé permet donc de contrôler, via le processus d'implantation ionique, la puissance limite d'un signal radiofréquence à transmettre par le limiteur 18 ainsi que le temps de réponse à une impulsion du limiteur 18.

Selon un mode de réalisation spécifique, le procédé permet également de contrôler d'autres paramètres, comme la hauteur H du plateau observé dans le comportement de la résistance en fonction de la température dans le cas du mode de réalisation de la figure 7.

Dans l'ensemble des cas, à l'étape d'application d'un traitement, la deuxième géométrie G2 et/ou le deuxième matériau supraconducteur M2 sont modifiés pour obtenir la première géométrie G1 et le premier matériau supraconducteur M1. Les modifications apportées par traitement assurent que la première température de transition T₁ soit strictement inférieure à la deuxième température de transition T₂.

Un des avantages de l'invention est que de nombreuses techniques de traitement sont connues de l'état de la technique et permettent une mise en œuvre aisée de l'invention proposée.

## Revendications

1. Dispositif (10) électronique de traitement d'ondes radiofréquences comportant une ligne (22), la ligne (22) présentant une deuxième géométrie (G2) et étant réalisée en un deuxième matériau supraconducteur (M2), la ligne (22) présentant une phase normale, une phase supraconductrice et une température de transition entre la phase supraconductrice et la phase normale, dite deuxième température de transition (T₂), la ligne (22) comportant un limiteur (18) de puissance radiofréquence, le limiteur (18) ayant un premier mode de fonctionnement et un deuxième mode de fonctionnement, le limiteur (18) étant réalisé sous forme d'une portion de la ligne (22) présentant une première géométrie (G1) et étant réalisée en un premier matériau supraconducteur (M1), la portion présentant une phase supraconductrice et une phase normale, une température de transition vers la phase supraconductrice, dite première température de transition (T₁), le limiteur (18) étant dans le premier mode de fonctionnement lorsque la portion est dans la phase supraconductrice et le limiteur (18) étant dans le deuxième mode de fonctionnement lorsque la portion est dans la phase normale, au moins l'un parmi la première géométrie (G1) et le premier matériau supraconducteur (M1) différant de la deuxième géométrie (G2) et du deuxième matériau supraconducteur (M2) pour que la première température de transition (T₁) soit strictement inférieure à la deuxième température de transition (T₂), **caractérisé en ce que** le premier matériau supraconducteur (M1) comporte au moins une première zone (Z1) en un troisième matériau supraconducteur (M3) et au moins une deuxième zone (Z2) réalisée en deuxième matériau supraconducteur (M2), le troisième matériau supraconducteur (M3) étant différent du premier matériau supraconducteur (M1) et du deuxième matériau supraconducteur (M2).

2. Dispositif selon la revendication 1, dans lequel la différence entre la première température de transition (T₁) et la deuxième température de transition (T₂) est supérieure ou égale à 10 K.

3. Dispositif selon la revendication 2, dans lequel la différence entre la première température de transition (T₁) et la deuxième température de transition (T₂) est supérieure ou égale à 20 K.

4. Dispositif selon l'une quelconque des revendications 1 à 3, dans lequel le premier matériau supraconducteur (M1) est obtenu à partir du deuxième matériau supraconducteur (M2) par implantations d'ions.

5. Dispositif selon l'une quelconque des revendications 1 à 4, dans lequel la deuxième zone (Z2) est continue.

6. Dispositif selon l'une quelconque des revendications 1 à 5, dans lequel chaque première zone (Z1) présente la forme d'un disque.

7. Dispositif selon l'une quelconque des revendications 1 à 6, dans lequel le premier matériau supraconducteur (M₁) comporte des défauts destinés à piéger des vortex.

8. Procédé de fabrication d'un dispositif (10) électronique de traitement d'ondes radiofréquences, le procédé comprenant :
- la fourniture d'une ligne (22) présentant une deuxième géométrie (G2) et étant réalisée en un deuxième matériau supraconducteur (M2), la ligne (22) présentant une phase normale, une phase supraconductrice et une température de transition entre la phase supraconductrice et la phase normale, dite deuxième température de transition (T₂), et
- application d'un traitement sur une portion de la ligne (22) pour obtenir un limiteur (18) de puissance radiofréquence, le limiteur (18) ayant un premier mode de fonctionnement et un deuxième mode de fonctionnement, le limiteur (18) étant réalisé sous forme d'une portion de la ligne (22) présentant une première géométrie (G1) et étant réalisée en un premier matériau supraconducteur (M1), la portion présentant une phase supraconductrice et une phase normale, une température de transition vers la phase supraconductrice, dite première température de transition (T₁), le limiteur (18) étant dans le premier mode de fonctionnement lorsque la portion est dans la phase supraconductrice et le limiteur étant dans le deuxième mode de fonctionnement lorsque la portion est dans la phase normale, au moins l'un parmi la première géométrie (G1) et le premier matériau supraconducteur (M1) différant de la deuxième géométrie (G2) et du deuxième matériau supraconducteur (M2) pour que la première température de transition (T₁) soit strictement inférieure à la deuxième température de transition (T₂), **caractérisé en ce que** le premier matériau supraconducteur (M1) comporte au moins une première zone (Z1) en un troisième matériau supraconducteur (M3) et au moins une deuxième zone (Z2) réalisée en deuxième matériau supraconducteur (M2), le troisième matériau supraconducteur (M3) étant différent du premier matériau supraconducteur (M1) et du deuxième matériau supraconducteur (M2).

## Patentansprüche

1. Elektronische Vorrichtung (10) zur Verarbeitung von Funkfrequenzwellen, aufweisend eine Leitung (22), wobei die Leitung (22) eine zweite Geometrie (G2) aufweist und aus einem zweiten supraleitenden Material (M2) besteht, wobei die Leitung (22) eine Normalphase, eine supraleitende Phase und eine Temperatur zum Übergang zwischen der supraleitenden Phase und der Normalphase, zweite Übergangstemperatur (T₂) genannt, aufweist, wobei die Leitung (22) einen Funkfrequenz-Leistungsbegrenzer (18) aufweist, wobei der Begrenzer (18) einen ersten Betriebsmodus und einen zweiten Betriebsmodus aufweist, wobei der Begrenzer (18) als ein Abschnitt der Leitung (22) mit einer ersten Geometrie (G1) ausgebildet ist und aus einem ersten supraleitenden Material (M1) hergestellt ist, wobei der Abschnitt eine supraleitende Phase und eine Normalphase und eine Temperatur zum Übergang in die supraleitende Phase, erste Übergangstemperatur (T₁) genannt, aufweist, wobei der Begrenzer (18) in dem ersten Betriebsmodus ist, wenn sich der Abschnitt in der supraleitenden Phase befindet, und der Begrenzer (18) in dem zweiten Betriebsmodus ist, wenn sich der Abschnitt in der Normalphase befindet, wobei mindestens eines von der ersten Geometrie (G1) und dem ersten supraleitende Material (M1) sich von der zweiten Geometrie (G2) und dem zweiten supraleitenden Material (M2) unterscheidet, so dass die erste Übergangstemperatur (T₁) echt kleiner ist als die zweite Übergangstemperatur (T₂), **dadurch charakterisiert, dass**
das erste supraleitende Material (M1) mindestens eine erste Zone (Z1) aus einem dritten supraleitenden Material (M3) und mindestens eine zweite Zone (Z2) aus einem zweiten supraleitenden Material (M2) aufweist, wobei sich das dritte supraleitende Material (M3) vom ersten supraleitenden Material (M1) und dem zweiten supraleitenden Material (M2) unterscheidet.

2. Vorrichtung nach Anspruch 1, wobei die Differenz zwischen der ersten Übergangstemperatur (T1) und der zweiten Übergangstemperatur (T2) größer oder gleich 10 K ist.

3. Vorrichtung nach Anspruch 2, wobei die Differenz zwischen der ersten Übergangstemperatur (T₁) und der zweiten Übergangstemperatur (T₂) 20 K oder mehr beträgt.

4. Vorrichtung nach einem der Ansprüche 1 bis 3, wobei das erste supraleitende Material (M1) aus dem zweiten supraleitenden Material (M2) durch lonenimplantation erhalten wird.

5. Vorrichtung nach einem der Ansprüche 1 bis 4, wobei die zweite Zone (Z2) kontinuierlich ist.

6. Vorrichtung nach einem der Ansprüche 1 bis 5, wobei jede erste Zone (Z1) die Form einer Scheibe aufweist.

7. Vorrichtung nach einem der Ansprüche 1 bis 6, wobei das erste supraleitende Material (M₁) Defekte zum Einfangen von Wirbeln aufweist.

8. Verfahren zur Herstellung einer elektronischen Vorrichtung (10) zur Verarbeitung von Funkfrequenzwellen, wobei das Verfahren aufweist:
- die Bereitstellung einer Leitung (22) mit einer zweiten Geometrie (G2), die aus einem zweiten supraleitenden Material (M2) besteht, wobei die Leitung (22) eine Normalphase, eine supraleitende Phase und eine Temperatur zum Übergang zwischen der supraleitenden Phase und der Normalphase, genannt zweite Übergangstemperatur (T2), aufweist und
- Anwendung einer Behandlung auf einen Abschnitt der Leitung (22), um einen Funkfrequenz-Leistungsbegrenzer (18) zu erhalten, wobei der Begrenzer (18) einen ersten Betriebsmodus und einen zweiten Betriebsmodus aufweist, wobei der Begrenzer (18) in Form eines Abschnitts der Leitung (22) mit einer ersten Geometrie (G1) ausgebildet ist und aus einem ersten supraleitenden Material (M1) hergestellt ist, wobei der Abschnitt eine supraleitende Phase und eine Normalphase, eine Temperatur zum Übergang in die supraleitende Phase, genannt erste Übergangstemperatur (T₁), aufweist, wobei der Begrenzer (18) in dem ersten Betriebsmodus ist, wenn sich der Abschnitt in der supraleitenden Phase befindet, und der Begrenzer in dem zweiten Betriebsmodus ist, wenn sich der Abschnitt in der Normalphase befindet, wobei sich mindestens eines von der ersten Geometrie (G1) und dem ersten supraleitenden Material (M1) von der zweiten Geometrie (G2) und dem zweiten supraleitende Material (M2) unterscheidet, so dass die erste Übergangstemperatur (T₁) deutlich niedriger ist als die zweite Übergangstemperatur (T2), **dadurch charakterisiert, dass**
das erste supraleitende Material (M1) mindestens eine erste Zone (Z1) aus einem dritten supraleitenden Material (M3) und mindestens eine zweite Zone (Z2) aus einem zweiten supraleitenden Material (M2) aufweist, wobei sich das dritte supraleitende Material (M3) vom ersten supraleitenden Material (M1) und dem zweiten supraleitenden Material (M2) unterscheidet.

## Claims

1. Electronic device (10) for processing radiofrequency waves, comprising a line (22), the line (22) having a second geometry (G2) and being made of a second superconducting material (M2), the line (22) having a normal phase, a superconducting phase and a transition temperature between the superconducting phase and the normal phase, referred to as the second transition temperature (T₂), the line (22) comprising a radiofrequency power limiter (18), the limiter (18) having a first operating mode and a second operating mode, the limiter (18) being in the form of a portion of the line (22) that has a first geometry (G1) and that is made of a first superconducting material (M1), the portion having a superconducting phase and a normal phase, a transition temperature to the superconducting phase, referred to as the first transition temperature (T₁), the limiter (18) being in the first operating mode when the portion is in the superconducting phase and the limiter (18) being in the second operating mode when the portion is in the normal phase, at least one of the first geometry (G1) and the first superconducting material (M1) being different from the second geometry (G2) and the second superconducting material (M2) in order that the first transition temperature (T₁) is strictly below the second transition temperature (T₂), **characterised in that** the first superconducting material (M1) comprises at least one first zone (Z1) made of a third superconducting material (M3) and at least one second zone (Z2) made of second superconducting material (M2), the third superconducting material (M3) being different from the first superconducting material (M1) and the second superconducting material (M2).

2. Device according to claim 1, wherein the difference between the first transition temperature (T₁) and the second transition temperature (T₂) is greater than or equal to 10 K.

3. Device according to claim 2, wherein the difference between the first transition temperature (T₁) and the second transition temperature (T₂) is greater than or equal to 20 K.

4. Device according to any one of claims 1 to 3, wherein the first superconducting material (M1) is obtained from the second superconducting material (M2) by ion implantation.

5. Device according to any one of claims 1 to 4, wherein the second zone (Z2) is continuous.

6. Device according to any one of claims 1 to 5, wherein each first zone (Z1) has the shape of a disc.

7. Device according to any one of claims 1 to 6, wherein the first superconducting material (M₁) comprises defects for trapping vortices.

8. Method for manufacturing an electronic device (10) for processing radiofrequency waves, the method comprising:
- providing a line (22) having a second geometry (G2) and being made of a second superconducting material (M2), the line (22) having a normal phase, a superconducting phase and a transition temperature between the superconducting phase and the normal phase, referred to as the second transition temperature (T₂), and
- applying a treatment to a portion of the line (22) in order to obtain a radiofrequency power limiter (18), the limiter (18) having a first operating mode and a second operating mode, the limiter (18) being in the form of a portion of the line (22) that has a first geometry (G1) and that is made of a first superconducting material (M1), the portion having a superconducting phase and a normal phase, a transition temperature to the superconducting phase, referred to as the first transition temperature (T₁), the limiter (18) being in the first operating mode when the portion is in the superconducting phase and the limiter being in the second operating mode when the portion is in the normal phase, at least one of the first geometry (G1) and the first superconducting material (M1) being different from the second geometry (G2) and the second superconducting material (M2) in order that the first transition temperature (T₁) is strictly below the second transition temperature (T₂),
**characterised in that** the first superconducting material (M1) comprises at least one first zone (Z1) of a third superconducting material (M3) and at least one second zone (Z2) made of second superconducting material (M2), the third superconducting material (M3) being different from the first superconducting material (M1) and the second superconducting material (M2).
